(19) Europäisches Patentamt
European Patent Office
Office européen des brevets

(11) Publication number: **0 075 678**
**B1**

(12) **EUROPEAN PATENT SPECIFICATION**

(45) Date of publication of patent specification: **30.09.87**

(51) Int. Cl.⁴: **H 01 L 29/72,** H 01 L 29/52

(21) Application number: **82106904.4**

(22) Date of filing: **30.07.82**

(54) **Semiconductor device having a Schottky diode.**

(30) Priority: **31.07.81 JP 120109/81**

(43) Date of publication of application:
**06.04.83 Bulletin 83/14**

(45) Publication of the grant of the patent:
**30.09.87 Bulletin 87/40**

(84) Designated Contracting States:
**DE FR GB NL**

(56) References cited:
**FR-A-2 452 179**
**US-A-3 749 987**

(73) Proprietor: **Kabushiki Kaisha Toshiba**
**72, Horikawa-cho Saiwai-ku**
**Kawasaki-shi Kanagawa-ken 210 (JP)**

(72) Inventor: **Koyanagi, Tsutomu**
**89-1-323, Mitsukyo**
**Seya-ku Yokohama-shi (JP)**
Inventor: **Kimura, Junzou**
**4-98, Komukainishi-machi**
**Saiwai-ku Kawasaki-shi (JP)**

(74) Representative: **Lehn, Werner, Dipl.-Ing. et al**
**Hoffmann, Eitle & Partner Patentanwälte**
**Arabellastrasse 4**
**D-8000 München 81 (DE)**

**EP 0 075 678 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to semiconductor devices having vertical transistors.

It is generally known that a bipolar transistor is turned on or off according to the base current. In this case, the time TON required to turn on a transistor and the time TOFF required to turn it off are represented by the following formulas:

$$TON=TD+TG \quad (1)$$

$$TOFF=TS+TF \quad (2)$$

Here, TD is the delay time from a time t0 when the base current of a specific level to turn on the transistor is applied, as illustrated in Fig. 1A, to a time when the collector current IC begins to rise, as illustrated in Fig. 1B; TG is the rise time in which the collector current IC reaches to 90% of the saturation value; TS is the carrier storage time from a time t1 when the negative base current to turn off the transistor is applied, as illustrated in Fig. 1A, to a time when the operational state of the transistor reaches the boundary between the saturation region and the active region; and TF is the fall time in which the collector current reaches from the saturation value ICS to 0.1 ICS.

The switching characteristic of the transistor is largely influenced by the carrier storage time TS. To improve the switching characteristic, the transistor is so designed as to shorten the carrier storage time TS. The carrier storage time TS represents the time in which the density of the minority carriers existing in the collector and base of the transistor in the saturation region is reduced to the density of the minority carriers existing in the collector and base at an operational transistion to the active region from the saturation region. The carrier storage time is then dependent on the extent of saturation in the transistor. In order to shorten the carrier storage time TS, a Schottky barrier diode is generally coupled in the forward direction between the collector and the base of a transistor, so that an excessively large bias voltage is not applied between the collector and the base.

Fig. 2 is a sectional view of the vertical npn transistor device which is well known. The vertical npn transistor includes a p-type region 2 and an $n^+$-type region 4, both formed in the surface area of the n-type substrate 6, and an $n^+$-type region 8 formed in the surface area of the p-type region 2. To the $n^+$-type region 8, and p-type region 2 and $n^+$-type region 4 are coupled an emitter electrode 10, base electrode 12 and collector electrode 14, respectively.

In a case where the transistor is in a saturation state, the junction region between the base and emitter and the junction region between the base and collector are both biased in the forward direction. In this case, the voltage between the emitter and the base is 0.6 V, for example, and the voltage between the collector and the base is 0.5 V, for example, so that the voltage between the collector and the emitter becomes very low, i.e., 0.1 V. The low voltage between the collector and the emitter indicates that the extent of saturation of the transistor is large, and that the density of the minority carriers in the collector and base regions is considerably large compared with the density of the minority carriers in the collector and base regions of the transistor in the active region.

A semiconductor device according to the preamble of claim 1 including a vertical transistor together with a Schottky barrier diode which is appropriately placed in parallel to the collector base junction in order to improve the switching characteristic is already known from FR—A—2 452 179.

Fig. 3 is a sectional view of such a vertical npn transistor with a Schottky barrier diode coupled between the collector and the base. Fig. 4 is an equivalent circuit diagram of this transistor device.

The transistor device illustrated in Fig. 3 is constructed similarly to the transistor device illustrated in Fig. 2, except that in place of the base electrode 12, a base electrode 13 which is coupled to the p-type region 2 and the n-type substrate 6 used as the base and the collector is employed. The base electrode 13 is formed directly on the N-type substrate 6, so that a Schottky barrier diode is formed between the base electrode 13 and the n-type substrate 6. That is, as illustrated in Fig. 4 a Schottky barrier diode SD is coupled in the forward direction between the base and the collector of the npn transistor TR. Voltage-current characteristic of the Schottky barrier diode SD is determined by the kind of metal material forming the base electrode 13, the kind of semiconductor material forming the n-type substrate 6, and the concentration of impurity. Fig. 5 illustrates voltage-current characteristic of the Schottky barrier diode in which an aluminum electrode is used for the base electrode 13 and an n-type silicon substrate with an impurity concentration of $10^{15}$ to $10^{16}$ atoms/$cm^3$ is used as the n-type substrate 6. As is apparent from Fig. 5, the forward current in this Schottky barrier diode rises to the operational region at a forward voltage of about 0.4 V. Accordingly, in a case where the operational state of the transistor is in the saturation region, the forward voltage between the collector and the base does not exceed the level of 0.4 V, so that the voltage between the collector and the emitter does not fall below the level of (0.6—0.4) V. That is, in a case where a transistor of the construction illustrated in Fig. 3 is in the saturation region, the density of the minority carries in the base and collector regions is suppressed to a small value compared with the case of the transistor illustrated in Fig. 2. Therefore, in a case where the transistor is to be turned off, the time required to discharge the minority carriers to their specific density, i.e., the carrier storage time TS, is shortened.

Incidentally, the integrated injection logic ($I^2L$) inverter having horizontal pnp transistors and

vertical npn transistors is used practically as a highly integrated bipolar logic circuit. To raise the operational speed of the $I^2L$ inverter, it is important to improve the switching characteristic of the vertical transistor. The vertical transistor, as illustrated in Fig. 6, for example, includes a p-type region 22 and an $n^+$-type region 24, both formed in the surface area of an n-type substrate 26 used as the emitter region, and an $n^+$-type region 28 used as the collector region formed in the surface region of the p-type region 22 used as the base region. To the $n^+$-type region 28, p-type region 22 and $n^+$-type region 24 are coupled a collector electrode 30, base electrode 32 and emitter electrode 34, respectively.

In the above transistor device, in order to form a Schottky barrier diode between the base and the collector, it is conceivable to form an extension of the $n^+$-type region 28 and to form the electrode 30 so as to be in contact with the p-type region 22 and the extended portion of the $n^+$-type region 28. However, since the extended portion of the $n^+$-type region 28 is of high impurity concentration, a Schottky barrier diode cannot be formed between the extended portion of the $n^+$-type region 28 and the base electrode 32.

Therefore, it has been conventionally conceived to employ an $n^-$-type substrate 40 of low impurity concentration for construction of the vertical transistor, as illustrated in Fig. 7. In the surface area of the $n^-$-type substrate 40 used as the emitter region, a p-type outer base region 42 and a p-type inner base region 43 are first formed. In this case, the inner base region 43 is so formed as to define an $n^-$-type island region 44 jointly with the outer base region 42 by implanting a p-type impurity, e.g., boron deep in the $n^-$-type substrate 40 by, for example, the ion implantation method. An $n^-$-type region 46 used as the collector region is formed in contact with the $n^-$-type island region 44. An $n^+$-type region 48 is also formed in the surface area of the $n^-$-type substrate 40. Subsequently in contact with the $n^+$-type region 46, p-type region 42 and $n^+$-type region 48 a collector electrode 50, base electrode 52 and emitter electrode 54 are formed, respectively. The base electrode 52 is formed to be in contact with the $n^-$-type island region 44 and constitutes a Schottky barrier diode jointly with the $n^-$-type island region 44.

In the transistor device illustrated in Fig. 7, an equivalent circuit similar to that illustrated in Fig. 4 is obtained. As described referring to Fig. 3 through Fig. 5, the switching characteristic is improved. However, in a case where the inner base region 43 is formed, a p-type impurity is implanted in the $n^-$-type substrate 40 by the ion implantation method so as to leave the $n^-$-type region 44 over the region 43. Therefore, at the time of the ion implantation, it is required to give extremely large acceleration energy to the impurity atoms. Concentration profiles of the implanted impurity are thus extended, so that the width of the inner base region 43 may vary according to variation in the concentration in the substrate 40. Consequently, it becomes difficult to maintain uniformity in electrical characteristics such as the current-amplification factor. Moreover, in the case where an impurity is implanted with high acceleration energy, lattice defects are occasionally induced in the substrate 40 or the island region 44 where the impurity atoms pass, thereby leading to the possibility of large leak current.

An object of the present invention is to provide a semiconductor device including a vertical transistor with an excellent switching characteristic.

The object is attained by providing a semiconductor device having a vertical bipolar transistor with a Schottky barrier diode coupled between collector and base comprising a semiconductor substrate of one conductivity type, a first semiconductor region of opposite conductivity type formed in the surface area of the semiconductor substrate, a second semiconductor region of one conductivity type formed in the surface area of the first semiconductor region and a metal electrode electrically connected to the first semiconductor region, said substrate, first semiconductor region and second semiconductor region respectively constituting a vertical bipolar transistor. A semiconductor layer of one conductivity type is formed over the substrate electrically isolated from the first semiconductor region said semiconductor layer being electrically connected to the second semiconductor region and in contact with the metal electrode and having an impurity concentration lower than that of the second semiconductor region so as to constitute a Schottky barrier diode jointly with the metal electrode.

In the invention, because the semiconductor layer is formed over the substrate, not in the substrate, a Schottky barrier diode can be easily constructed.

This invention can be more fully understood from the following detailed description when taken in conjunction with the accompanying drawings, in which:

Figs. 1A and 1B show current waveforms for illustrating the switching characteristic of a transistor;

Fig. 2 is a sectional view of part of a conventional vertical transistor device;

Fig. 3 is a sectional view of part of a conventional vertical transistor device having a Schottky barrier diode between the base and the collector;

Fig. 4 is an equivalent circuit diagram of the transistor device shown in Fig. 3;

Fig. 5 is a graph illustrating voltage-current characteristic of a Schottky barrier diode;

Fig. 6 is a sectional view of part of a conventional vertical transistor device with the substrate used as the emitter;

Fig. 7 is a sectional view of part of the vertical transistor device shown in Fig. 6 with a Schottky barrier diode formed; and

Figs. 8A through 8F show a manufacturing process of a transistor device according to one embodiment of the present invention.

A manufacturing process of a semiconductor

device according to one embodiment of the present invention will be described with reference to Figs. 8A to 8F.

As illustrated in Fig. 8A, in an $n^-$-type substrate 62, for example, a p-type base region 60 is first formed in the surface area by the diffusion method or the ion injection method. Then, an insulating layer 64 is formed on the p-type base region 60 and the $n^-$-type substrate 62. As illustrated in Fig. 8B, by partly removing the insulating layer 64 by selective etching, openings 65 and 66 are then formed to expose part of the p-type base region 60 and part of the $n^-$-type substrate 62. Subsequently, polycrystalline silicon layer 68 doped with an n-type impurity at a low impurity concentration is formed to a predetermined thickness on the insulating layer 64 and the exposed surface of the p-type base region 60 and the exposed surface of the $n^-$-type substrate 62.

Then, as illustrated in Fig. 8C, the polycrystalline silicon layer 68 is removed in part by selective etching, leaving the partial layers 68-1 and 68-2 in the openings 65 and 66, and over the regions surrounding the openings 65 and 66. The polycrystalline silicon layer 68-1 has a main portion 68-11 and an extension portion 68-12 extending from the main portion 68-11 over a partial region of the insulating layer 64 on the p-type base region 60.

As illustrated in Fig. 8D, silicon oxide films 70 and 71 are then formed on the polycrystalline silicon layers 68-1 and 68-2, respectively. Subsequently, through the silicon oxide films 70 and 71, an n-type impurity such as phosphorus or arsenic is implanted by the ion implantation method into the main portion 68-11 of the polycrystalline silicon layer 68-1 and the polycrystalline silicon layer 68-2 at a high impurity concentration.

Then as illustrated in Fig. 8E, the semiconductor structure obtained in Fig. 8D is placed under high diffusion temperature in order to diffuse the n-type impurity at a high impurity concentration from the main portion 68-11 and the polycrystalline silicon layer 68-2 into the surface regions of the p-type base region 60 and the substrate 62. As a result, an $n^+$-type collector region 72 and an $n^+$-type collector region 73 are formed in the surface regions of the p-type base region 60 and the substrate 62 respectively.

As illustrated in Fig. 8F, the insulating layer 70 is subsequently removed in part by selectively etching in the portion of the middle part of the main portion 68-11 and the portion of the tip part of the extension portion 68-12. Similarly, the insulating layer 71 is partly removed by etching in the corresponding portion in the middle part of the polycrystalline silicon layer 68-2. In this case, the insulating layer 64 is also removed in part by selective etching, so that part of the p-type base region 60 is exposed. Subsequently, over the semiconductor structure thus obtained there is formed a metal layer of aluminum, platnium silicide (PtSi), or an aluminum silicide alloy such as aluminum silicide (AlSi) or aluminum silicide copper (Al-Si-Cu). The metal layer is then partly removed by selective by etching, so that as illustrated in Fig. 8F there are formed a collector electrode 74, a base electrode 75 and an emitter electrode 76.

As is apparent in Fig. 8F, the base electrode 75 is connected electrically to the p-type base region 60 and also to the tip portion of the extension portion 68-12, and constitutes a Schottky barrier diode in cooperation with the extension portion 68-12. The extension portion 68-12 is connected to the collector region 72 through the $n^+$-type base region 68-11, so that the Schottky barrier diode is coupled in the reverse direction between the base and the collector. That is, in the semiconductor device shown in Fig. 8F, a transistor device is obtained having an equivalent circuit similar to that shown in Fig. 4 and also having excellent switching characteristic.

As described with reference to Fig. 8A through Fig. 8F, according to the present invention, the semi-conductor layer 68-12 forming a Schottky barrier diode jointly with the base electrode 75 is formed on the semiconductor substrate 62, i.e., not within the semiconductor substrate 62. Therefore, a transistor device with an improved switching characteristic can be easily constructed.

Although, the present invention was described above by way of one embodiment, it is not limited to this one embodiment. For example, Fig. 8D illustrates an n-type impurity being doped in the main portion 68-11 and the region 68-2 through the insulating layers 70 and 71 respectively by the ion implantation method. However, it is also possible to dope an n-type impurity in the main portion 68-11 and the region 68-2 by the diffusion method after removing the parts of the insulating layers 70 and 71 corresponding to the main portion 68-11 and the region 68-2 respectively.

In the embodiment described above, a transistor device using the substrate as an emitter region was described. However, the present invention could also be used for any semiconductor device with a Schottky barrier diode formed between the $n^+$-type region 72 and the p-type region 60.

Furthermore, it is also possible to form a pnp transistor using a $p^-$-type substrate in place of the $n^-$-type substrate 62.

**Claims**

1. A semiconductor device having a vertical bipolar transistor with a Schottky barrier diode coupled between collector and base comprising a semiconductor substrate (62) of one conductivity type, a first semiconductor region (60) of opposite conductivity type formed in the surface area of the semiconductor substrate (62), a second semiconductor region (72) of one conductivity type formed in the surface area of the first semiconductor region (60) and a metal electrode (75) electrically connected to the first semiconductor region (60), said substrate (62), first semiconductor region (60) and second semiconductor region (72) constituting a vertical bipolar transistor,

characterized in that a semiconductor layer (68-12) of one conductivity type is formed over the substrate (62) electrically isolated from the first semiconductor region (60), said semiconductor layer (68-12) being electrically connected to the second semiconductor region (72) and in contact with the metal electrode (75) and having an impurity concentration lower than that of the second semiconductor region (72) so as to constitute a Schottky barrier diode jointly with the metal electrode (75).

2. A semiconductor device according to claim 1, characterized by further comprising a third semiconductor region (68-11) of one conductivity type formed in contact with said second semiconductor region (72) and with the semiconductor layer (68-12) and having an impurity concentration higher than that of the semiconductor region.

3. A semiconductor device according to claim 1 or 2, characterized in that the semiconductor layer (68-12) is formed of polycrystalline silicon.

4. A semiconductor device according to claim 1, 2 or 3, characterized in that the third semiconductor region (68-11) is formed of polycryslalline silicon.

5. A semiconductor device according to claim 2 or 4, characterized by further comprising a collector electrode (74) electrically connected to the third semiconductor region (68-11), a fourth semiconductor region (73) of one conductivity type formed in the surface area of the semiconductor substrate (62) and having an impurity concentration higher than that of the semiconductor substrate (62), and an emitter electrode (76) electrically connected to the fourth semiconductor region (73).

6. A semiconductor device according to claim 5, characterized by further comprising a fifth semiconductor region (68-2) of one conductivity type formed between the emitter electrode (76) and the fourth semiconductor region (73).

7. A semiconductor device according to claim 1, 2, 3 or 4, characterized in that the semiconductor substrate (62) is of $n^-$-type.

**Patentansprüche**

1. Halbleiteranordnung mit einem vertikalen bipolaren Transistor mit einer zwischen Kollektor und Basis geschalteten Schottky-Diode, enthaltend ein Halbleitersubstrat (62) eines Leitfähigkeitstyps, einen ersten, im Oberflächenbereich des Halbleitersubstrats (62) gebildeten Halbleiterbereich (60) entgegengesetzten Leitfähigkeitstyps, einen zweiten, im Oberflächenbereich des ersten Halbleiterbereichs (60) gebildeten Halbleiterbereich (72) des einen Leitfähigkeitstyps, und eine mit dem ersten Halbleiterbereich (60) elektrisch verbundene Metallelektrode (75), wobei das Substrat (62), der erste Halbleiterbereich (60) und der zweite Halbleiterbereich (72) einen vertikalen bipolaren Transistor bilden, dadurch gekennzeichnet, daß eine Halbleiterschicht (68-12) des einen Leitfähigkeitstyps über dem Substrat (62) elektrisch von dem ersten Halbleiterbereich (60) isoliert ausgebildet ist, wobei die Halbleiterschicht (68-12) elektrisch mit dem zweiten Halbleiterbereich (62) verbunden und in Kontakt mit der Metallelektrode (75) ist und eine Störstoffkonzentration niedriger als die des zweiten Halbleiterbereichs (72) aufweist, um gemeinsam mit der Metallelektrode (75) eine Schottky-Diode zu bilden.

2. Halbleiteranordnung nach Anspruch 1, dadurch gekennzeichnet, daß ein dritter, in Kontakt mit dem zweiten Halbleiterbereich (72) und mit der Halbleiterschicht (68-12) ausgebildeter Halbleiterbereich (68-11) des einen Leitfähigkeitstyp vorgesehen ist und eine Störstoffkonzentration größer als die des Halbleiterbereichs aufweist.

3. Halbleiteranordnung nach Anspruch 1 oder 2, dadurch gekennzeichnet, daß die Halbleiterschicht (68-12) aus polycrystallinem Silizium gebildet ist.

4. Halbleiteranordnung nach Anspruch 1, 2 oder 3, dadurch gekennzeichnet, daß der dritte Halbleiterbereich (68-11) aus polycristallinem Silizium gebildet ist.

5. Halbleiteranordnung nach Anspruch 2 oder 4, dadurch gekennzeichnet, daß eine, mit dem dritten Halbleiterbereich (68-11) elektrisch verbundene Kollektorelektrode (74) vorgesehenen ist, ein vierter Halbleiterbereich (73) des einen Leitfähigkeitstyps im Oberflächenbereich des Halbleitersubstrats (62) ausgebildet ist und eine Störstoffkonzentration größer als dus des Halbleitersubstrats (62) aufweist, und eine Emitter-Elektrode (76) vorgesehen ist, die mit dem vierten Halbleiterbereich (73) elektrisch verbunden ist.

6. Halbleiteranordnung nach Anspruch 5, dadurch gekennzeichnet, daß ein fünfter Halbleiterbereich (68-2) des einen Leitfähigkeitstyps zwischen der Emitter-Elektrode (76) und dem vierten Halbleiterbereich (73) ausgebildet ist.

7. Halbleiteranordnung nach Anspruch 1, 2, 3, oder 4, dadurch gekennzeichnet, daß das Halbleitersubstrat (62) vom $n^-$-Typ ist.

**Revendications**

1. Dispositif à semiconducteur comportant un transistor bipolaire vertical avec une diode à barrière de Schottky couplée entre le collecteur et la base, comprenant un substrat semiconducteur (62) d'un type de conductivité, une première région semiconductrice (60) d'un type de conductivité opposé formée dans la zone de surface du substrat semiconducteur (62), une deuxième région semiconductrice (72) d'un type de conductivité formée dans la zone de surface de la première région semiconductrice (60) et une électrode métallique (75) connectée électriquement à la première région semiconductrice (60), le substrat (62), la première région semiconductrice (60) et la deuxième région semiconductrice (72) constituant un transistor bipolaire vertical, caractérisé en ce qu'une couche semiconductrice (68-12) d'un type de conductivité est formée sur le substrat (62) en étant isolée électriquement de la première

région semiconductrice (60), la couche semiconductrice (68-12) étant connectée électriquement à la deuxième région semiconductrice (72) et en contact avec l'électrode métallique (75) et ayant une concentration en impuretés inférieure à celle de la deuxième région semiconductrice (72) de manière à constituer une diode à barrière de Schottky conjointement avec l'électrode métallique (75).

2. Dispositif à semiconducteur selon la revendication 1, caractérisé en ce qu'il comprend en outre une troisième région semiconductrice (68-11) d'un type de conductivité formée en contact avec la deuxième région semiconductrice (72) et avec la couche semiconductrice (68-12) et ayant une concentration en impuretés supérieure à celle de la région semiconductrice.

3. Dispositif à semiconducteur selon l'une quelconque des revendications 1 et 2, caractérisé en ce que la couche semiconductrice (68-12) est constituée de silicium polycristallin.

4. Dispositif à semiconducteur selon l'une quelconque des revendications 1 à 3, caractérisé en ce que la troisième région semiconductrice (68-11) est constituée de silicium polycristallin.

5. Dispositif à semiconducteur selon l'une quelconque des revendications 2 et 4, caractérisé en ce qu'il comprend en outre une électrode de collecteur (74) connectée électriquement à la troisième région semiconductrice (68-11), une quatrième région semiconductrice (73) d'un type de conductivité formée dans la zone de surface du substrat semiconducteur (62) et ayant une concentration en impuretés supérieure à celle du substrate semiconducteur (62), et une électrode d'émetteur (76) connectée électriquement à la quatrième région semiconductrice (73).

6. Dispositif à semiconducteur selon la revendication 5, caractérisé en ce qu'il comprend en outre une cinquième région semiconductrice (68-2) d'un type de conductivité formée entre l'électrode d'émetteur (76) et la quatrième région semiconductrice (73).

7. Dispositif à semiconducteur selon l'une quelconque des revendications 1 à 4, caractérisé en ce que le substrate semiconducteur (62) est de type $n^-$.

FIG. 1A

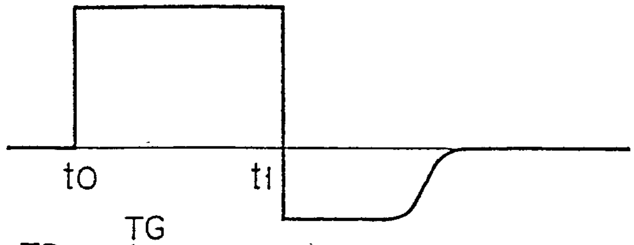


FIG. 1B

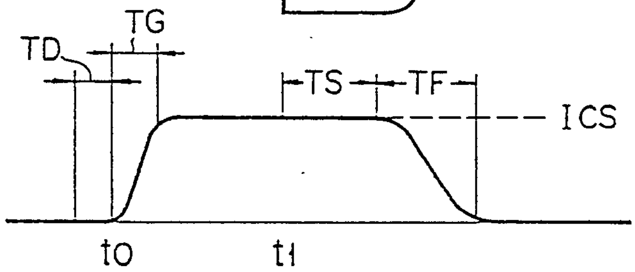


FIG. 2

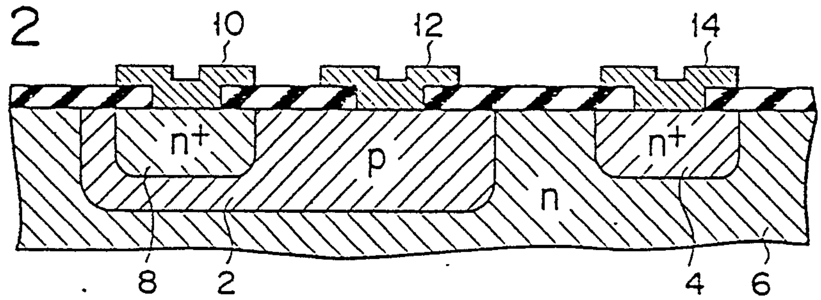


FIG. 3

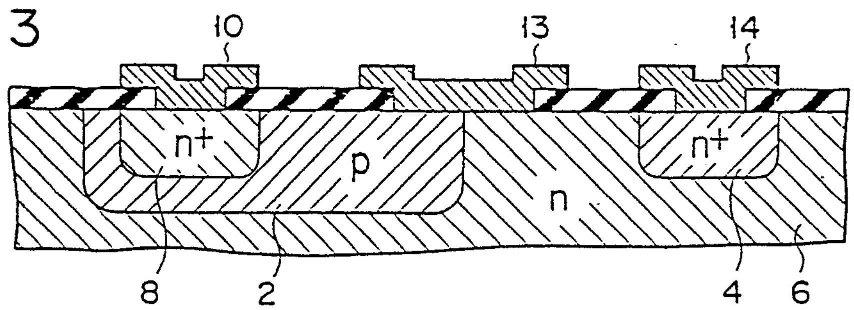


FIG. 4

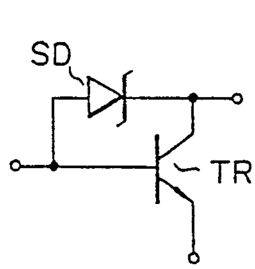

F I G. 5

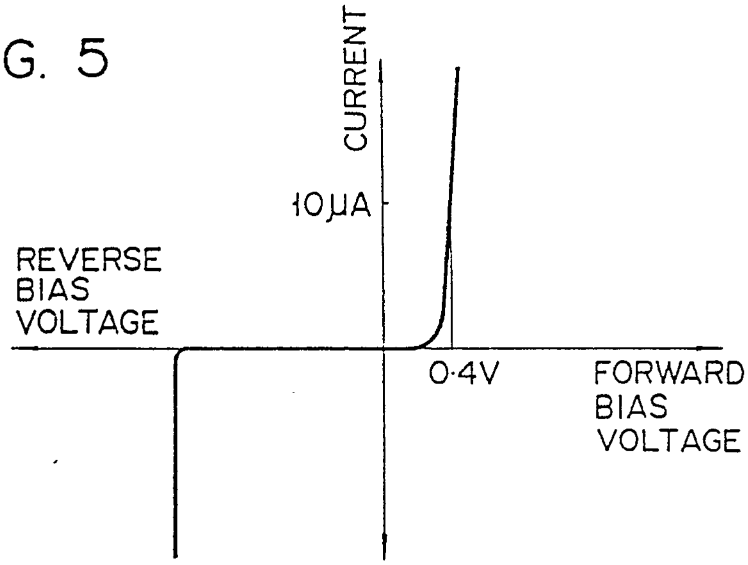


F I G. 6

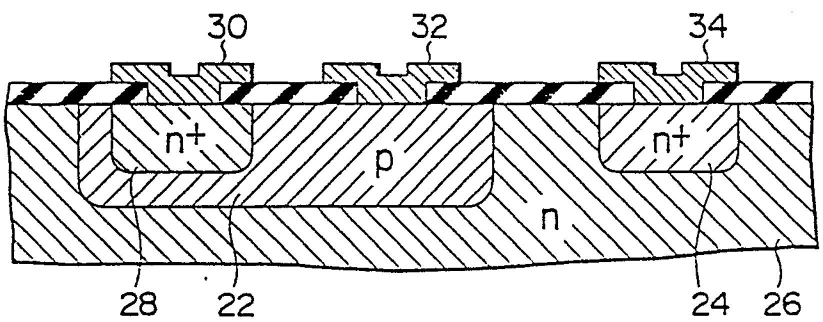


F I G. 7

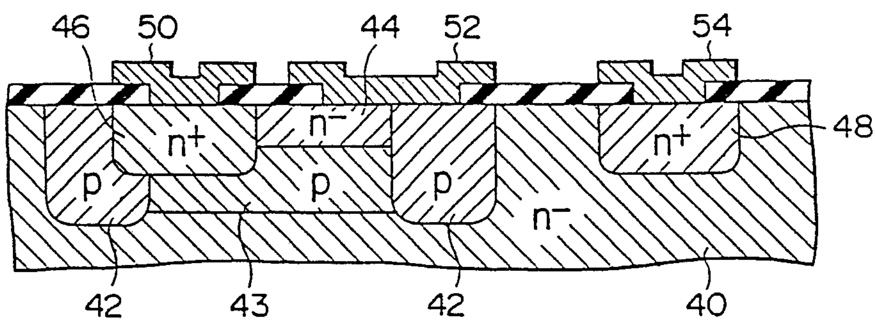

F I G. 8A

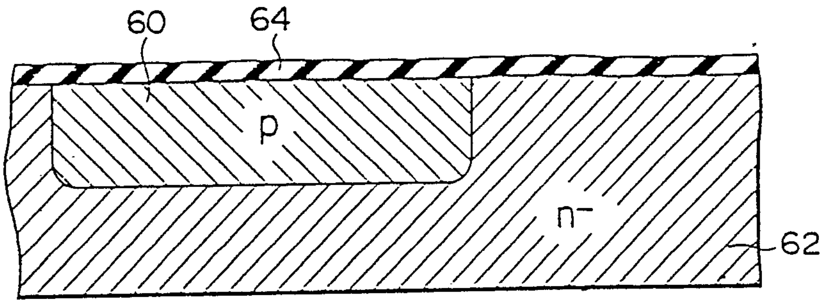


F I G. 8B

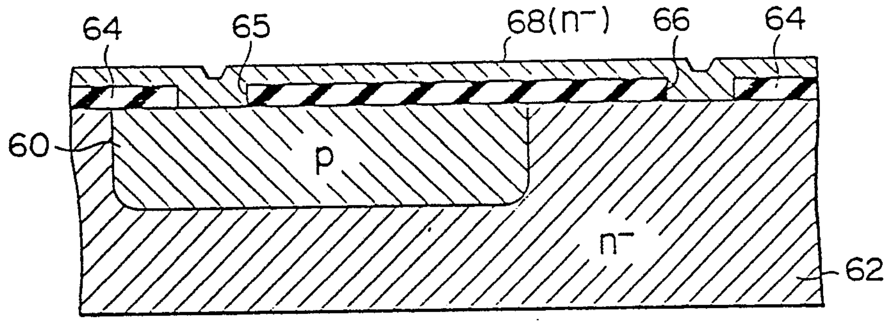


F I G. 8C

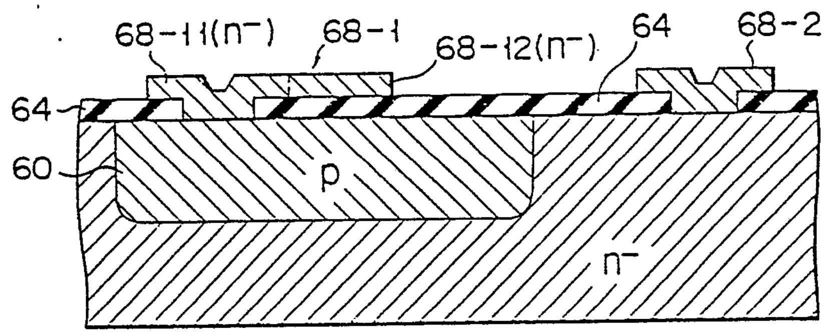


F I G. 8D

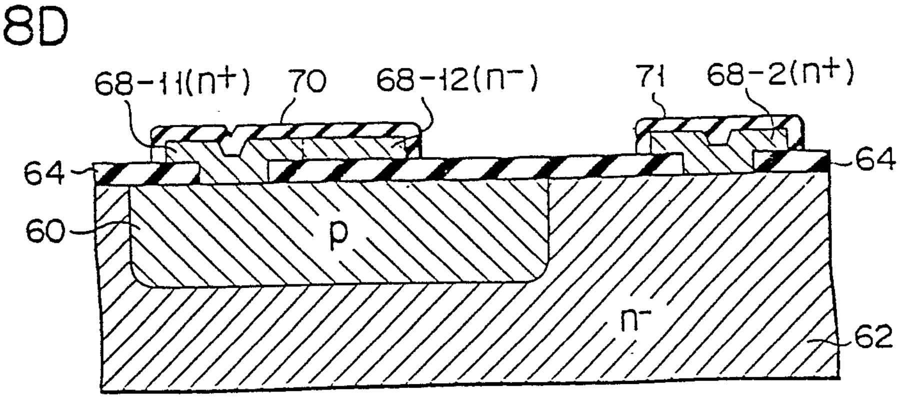

F I G. 8E

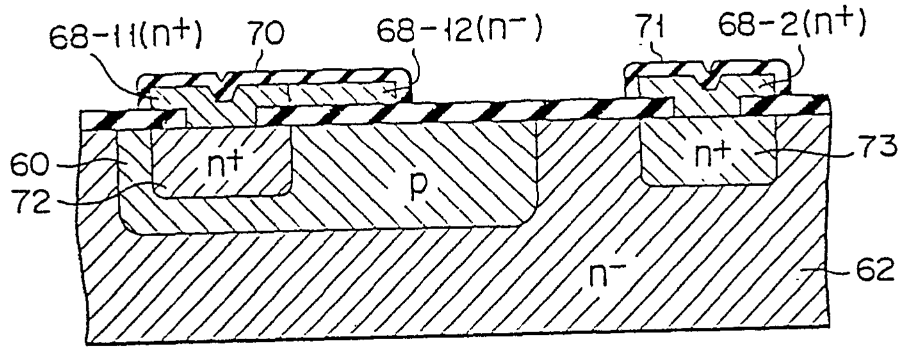

68-11(n+)
70
68-12(n−)
71
68-2(n+)
60
72
n+
p
n+
73
n−
62


F I G. 8F

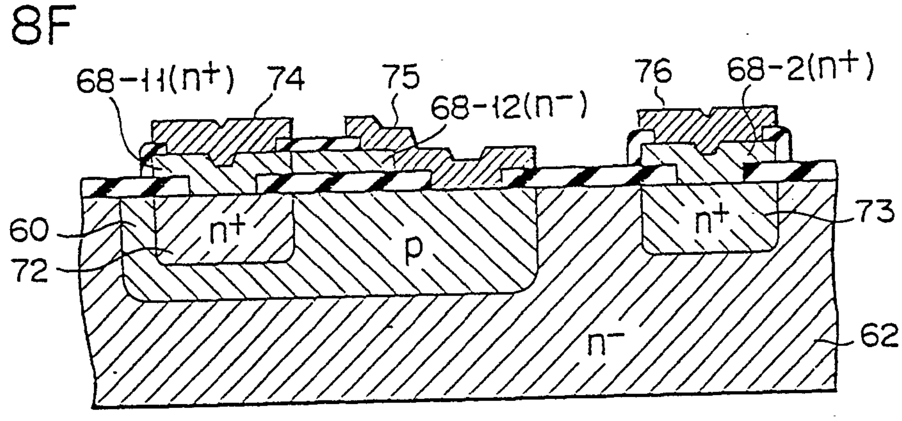

68-11(n+)
74
75
68-12(n−)
76
68-2(n+)
60
72
n+
p
n+
73
n−
62